# EUROPEAN PATENT APPLICATION

(11) **EP 1 605 743 A2**
(43) Date of publication of application: **14.12.2005**
(21) Application number: 05075716.0
(22) Date of filing: 29.03.2005
(51) Int. Cl.: H05K 13/00

(54) **Component placement apparatus and method**

(30) Priority: 11.06.2004 EP 04102655
(71) Applicant: Assembléon N.V., 5503 LA Veldhoven (NL)
(72) Inventor: Vermeer, Adrianus Johannes Petrus Maria, 5666 BW Geldrop (NL)
(74) Representative: Veldman-Dijkers, Cornelia G. C.

(57) **Abstract**

Component placement apparatus (1) comprising a tray storing device (14) for storing at least one tray (16) containing electronic components and a buffer (37) on which components picked up from the tray (16) by means of a first component pick and place device (36) are temporarily stored. The component placement apparatus (1) comprises also a second pick and place device (4) for picking up a component from the buffer (37) and placing the component on a substrate (101).

## Description

The invention relates to a component placement apparatus comprising a tray storing device for storing at least one tray containing electronic components and at least one component pick and place device.

The invention furthermore relates to a method for operating a component feeding device comprising a tray storing device for storing at least one tray containing electronic components and at least one component pick and place device.

Such a component placement device and method are known from the European patent application EP-A2-0.883.333. The component placement apparatus according to this European patent application comprises a component feeding device in which a carriage comprising several slots for trays for containing electronic components is movable in an upward and downward direction. The component feeding device comprises a tray transporting device by means of which a tray located in a slot is movable in a horizontal direction to a pickup area. By means of a component pick and place device a component is picked up from the tray in the pickup area and transported to a desired location on a substrate. After one or more components are being picked up from the tray, the tray is placed back in the same slot after which the carriage is moved in a vertical direction to align another slot comprising another tray with the tray transporting device.

A disadvantage of this component placement apparatus is that during exchange of the tray with a tray with other kind of components or in case that the tray has been emptied and is being replaced by a new tray with similar components, no component can be placed from the tray on the substrate.

It is an object of the invention to provide a component placement apparatus with a higher output.

This object has been achieved by the component placement apparatus according to the invention in that the component placement apparatus comprises a buffer on which components picked up from the tray by means of a first component pick and place device, are temporarily stored whilst the component placement apparatus comprises a second pick and place device for picking up a component from the buffer and placing the component on a substrate.

Due to the buffer, components can be placed by means of the second pick and place device from the buffer on the substrate whilst at the same time a tray exchange can take place. As soon as the desired tray is available in a pickup area, components will be transferred by means of the first pick and place device from the tray to the buffer.

Whilst components are being transferred from the tray to the buffer by means of the first pick and place device, components available in the component placement apparatus by other means like tape feeders, stick feeder, bulk feeders can be picked up and placed on the substrate by means of the second pick and place device.

An embodiment of the component placement apparatus according to the invention is characterized in that the buffer comprises at least one component pickup position in a pickup area on which a component can be temporarily stored.

In case that the buffer comprises only one component pickup position, it is preferably in line with pickup locations of other component feeding devices so that the positions on which the second component pick and place device may pick up a component are well defined. In case that the buffer comprises several component pickup positions, they can be located in a row, in several rows or random in a well-defined area.

Another embodiment of the component placement apparatus according to the invention is characterized in that it comprises a number of tape feeders each comprising a component pickup location, whereby the component pickup locations are in line with the at least one component pickup position of the buffer.

Since the component pickup position as well as the component pickup locations are in line with each other, there will be no differences for the second pick and place device between picking up components from component pickup locations or from components pickup positions of the buffer.

A yet further embodiment of the component placement apparatus according to the invention is characterized in that the buffer comprises a matrix of component pickup positions on which components can be temporarily stored.

In this manner the buffer may comprise a relatively large number of components which are located in a matrix of component pickup positions. Since the components are located in a matrix, the distances between the component pickup positions and the substrate can be relatively small and are well defined with respect to each other.

A further embodiment of the component placement apparatus according to the invention is characterized in that components can be temporarily stored on random positions on a pickup area of the buffer.

Hereby flexible use is being made of the entire space of the pickup area, whereby dependent on the size of different components maximum efficiency can be reached of the space on the buffer whereby a minimum distance between the pickup positions can be obtained.

Another embodiment of the component placement apparatus according to the invention is characterized in that the component placement apparatus comprises a controller for allocating the components to a specific position on the buffer and controlling the movement of the pick and place devices to place a component on and pick up a component from the correct position on the buffer.

With such a controller optimized use of the pickup area of the buffer can be achieved.

Preferably the controller comprises a collision prevention means for preventing collision between the pick and place devices.

With such a controller it is being prevented that at the same time a component is being placed on the buffer by the first pick and place device and another component is being picked up by the second pick and place device.

Yet another embodiment of the component placement apparatus according to the invention is characterized in that the buffer comprises at least one endless belt on which at least one component can be temporarily stored whilst the component can be moved by means of the endless belt from a position closer to the tray to a position closer to the substrate.

With such an endless belt the distances for both the first component pick and place device as well as the second component pick and place device between picking up a component and placing the component can be relatively small.

The invention will further be explained with reference to the drawings in which:
Fig. 1 is a top view of a component placement apparatus according to the invention,
Fig. 2 is a perspective view of a component feeding device according to the invention as used in the component placement device as shown in Fig. 1,
Fig. 3 is a top view of the component feeding device as shown in Fig. 2 incorporated in a trolley for feeding components in trays as well as components in tapes,
Fig. 4-6 are perspective views of three different embodiments of the buffer of a component placement device according to the invention.

Like parts are numbered alike in the figures.

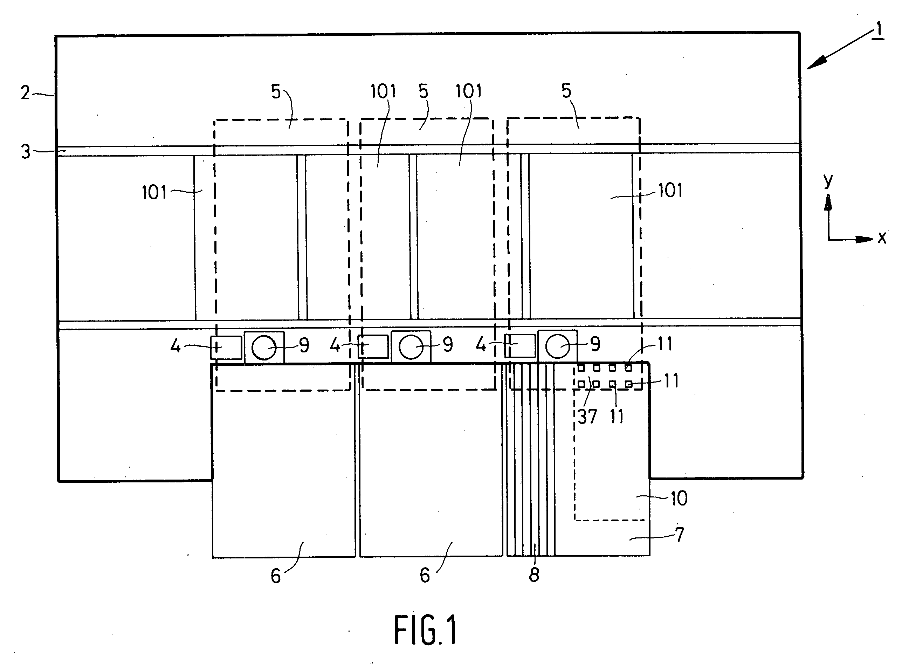

Fig. 1 shows a top view of a component placement apparatus 1 according to the invention, which apparatus is provided with a frame 2 in which a transport device 3 for transporting substrates is accommodated, which transport device can be indexed over certain distance in the positive X-direction by means which are not shown, whereupon the transport device 3 can be moved back into its starting position in the negative X-direction after said distance has been covered. Substrates 101 like printed circuit boards can be transported through the component placement apparatus 1 by the transport device 3. The component placement apparatus 1 is furthermore provided with three pick and place devices 4 which are provided with a vacuum tube or some other pickup member, which pick and place devices 4 are movable in and opposite to the X-direction as well as in an opposite to the Y-direction in an area 5 which is indicated by dotted lines. Near each pick and place device 4 is a trolley 6, 7 located. The trolley 6 is provided with a number of reels 8 (schematically shown in trolley 7) provided with tapes in which components are being stored. By means of the pick and place device 4 components are subsequently picked up from one of the reels 8, after which the position of the component with respect to the pick and place device 4 is detected by means of a component alignment device 9. Subsequently the component is placed on a desired location on the substrate 101 located in the area 5 of the respective pick and place device 4. Such a trolley 6 as well as reels 8 are known per se and will therefore not be further described.

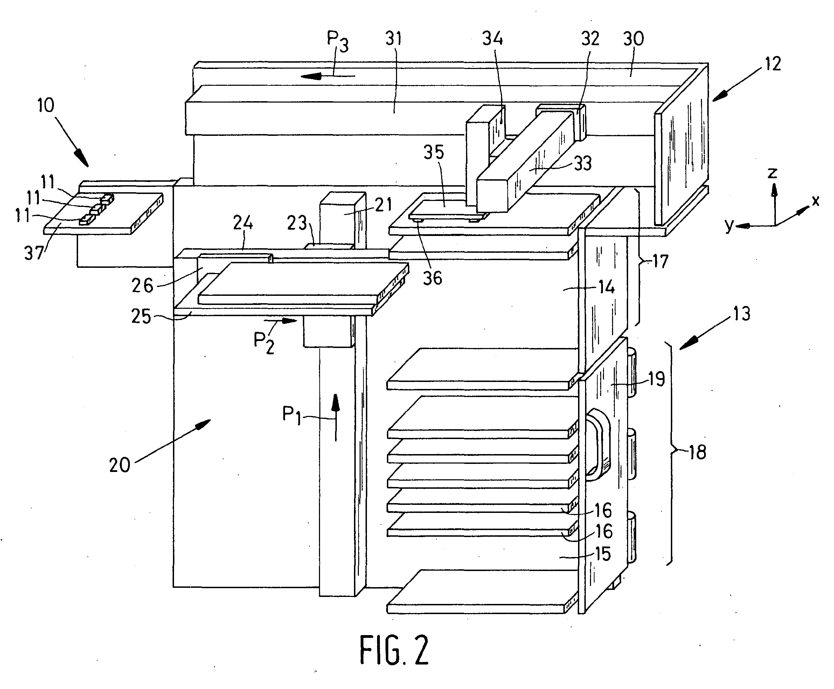

The trolley 7 also comprises reels 8 but furthermore comprises a component feeding apparatus 10 by means of which, as will be explained with reference to the Figs.2-7, components 11 can be presented in the area 5 of the pick and place device 4, which components were stored on trays 16 in the component feeding apparatus 10.

Fig. 2 shows a perspective view of the component feeding device 10 which comprises an upper part 12 and a lower part 13. The lower part 13 comprises a tray storing device 14 with a number of slots 15 for storing trays 16 one above each other, whereby each tray 16 contains electronic components. The slots 15 in an upper first part 17 are only accessible from the interior of the tray storing device 14 whilst the slots 15 in the lower, second part 18 of the tray storing device 14 are accessible from the interior as well as by means of a door 19 from the exterior. The lower part 13 furthermore comprises a tray transporting device 20. The tray transporting device 20 has a vertical column 21 along which a guide 23 is movable in and opposite to a direction indicated by arrow P1, parallel to the Z-direction. Attached to the guide 23 is a horizontally extending beam 24 and a horizontally extending platform 25. Along the beam 24 a gripping device 26 is movable in and opposite to a direction indicated by arrow P2, parallel to the Y-direction for moving a tray 16 in and out a slot 15.

The upper part 12 of the component feeding device 10 comprises a frame 30 provided with a beam 31 extending in the Y-direction. Along the beam 31 a guide 32 is movable in and opposite to a direction indicated by arrow P3, parallel to the Y-direction. Attached to said guide 32 is a beam 33 extending parallel to the X-direction along which a guide 34 is movable in and opposite to a direction indicated by arrow P4. Attached to the guide 34 is a plate 35 carrying a pick and place device 36 like a vacuum nozzle or a gripper. The upper part 12 furthermore comprises a buffer 37 on which components 11 are being presented to the pick and place device 4 of the component placement apparatus 1.

The operation of the component feeding device 10 according to the invention will now be explained. If no trays 16 are located in the slots 15, an operator will open door 19 and insert trays 16 in the slots 15 of the second part 18. Each tray 16 may comprise another kind of component. However, in case that one kind of component is expected to be needed in a relatively large amount, it is possible to insert a number of trays 16 with the same kind of components. The component placement apparatus 1 or the component feeding device 10 itself comprises a controller in which information is being loaded about which kind of component need to be placed on which position on a substrate by a specific pick and place device 4. From this information it is determined by the controller which components 11 need to be available on the buffer 37 in the short term. Subsequently the platform 25 is moved by means of the guide 23 along the vertical column 21 in or opposite to the direction indicated by arrow P1 until it is aligned with a slot 15 in which a tray 16 is located comprising the relevant components. By means of the gripper 26 the tray 16 is removed from the slot 15 and moved on the platform 25 upwardly until the tray 16 is located in the same horizontal X,Y-plane as the substrate 37. This location of the tray 16 is considered to be the pickup area of the component feeding apparatus 10. Then the pick and place device 36 is moved by means of the guides 32, 34 in and opposite to the directions indicated by the arrows P3, P4 respectively to pick up a component from the tray 16 and to place this component 11 on a desired location on the buffer 37.

Subsequently it is decided by the controller whether the tray will be needed in short term or not. If in very short term additional components from the tray 16 which is present in the pickup area are needed, these components will be placed on the buffer 37 as well. If it is determined by means of the controller that the tray 16 will be needed at the pickup area in the short term, it is transported by means of the tray transporting device 20 to an empty slot in the first part 17 of the tray storing device 14. If it is determined by the controller that the tray 16 is empty or that the tray 16 is not expected to be needed at the pickup area in the short term, the tray 16 is transported by means of the tray transporting device 20 to an empty slot 15 in the second part 18 of the tray storing device 14.

In this manner it is possible that by means of the controller the pick and place device 36 places as many components 11 on the buffer 37 as there are places available. These components 11 will be picked up by the pick and place device 4 to be placed on a desired location on a substrate in the area 5. If no tray 16 needs to be presented at the pickup area, it is determined by means of the controller whether the trays are already in their optimized position to be able to present the trays 16 as soon as possible to a pickup area in case that a tray 16 is needed. If it is determined by the controller that there is a tray 16 in the first part 17 which is expected not to be needed in the short term at the pickup area, this tray is being moved by means of the tray transporting device 20 in a manner described above to a slot 15 in the second part 18. In a similar way a tray 16 in the second part 18 which as determined by the controller, is expected to be needed at the pickup area in the short term is transferred to the first part 14.

In this manner trays comprising the same kind of components will all except one be located in the second part 18 whilst one of these trays will be located in the first part 17 closer to the pickup area. If this tray is emptied, it will be moved to the second part 18 whilst subsequently a full tray with the same kind of components will be moved to the first part 17. If an operator wants to replace empty trays by full trays 16 he may open the door 19. The opening of the door 19 will be detected by means of a switch (not shown) and this information will be transferred to the controller. As long as the door 19 is open the tray transporting device 20 will be controlled so that only trays 16 can be stored in the first part 17 and be removed therefrom. The operator can remove or replace only trays in the second part 18 so that any risk of interference between the tray transporting device 20 and the operator is being prevented.

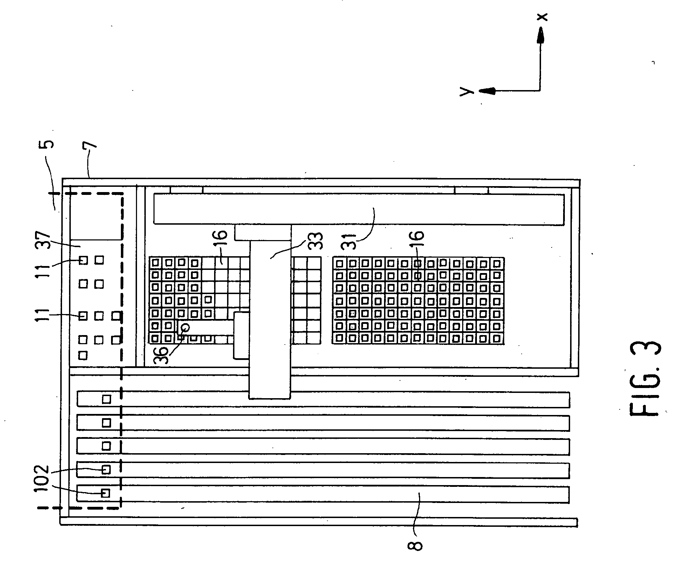

By the embodiment as shown in Figs. 1-3 the components 11 are being placed in the buffer 37 in a matrix. In this manner the positions of the components 11 are well defined and by means of the controller it is relatively easy to place the components by means of the first pickup device 36 on the buffer 37 and to pick up the components 11 by means of the second pickup device 4. As can be seen in Fig. 3 component pickup locations 102 of the reels 8 of the tape feeders are in line with each other but not with the component pickup positions of the buffer 37.

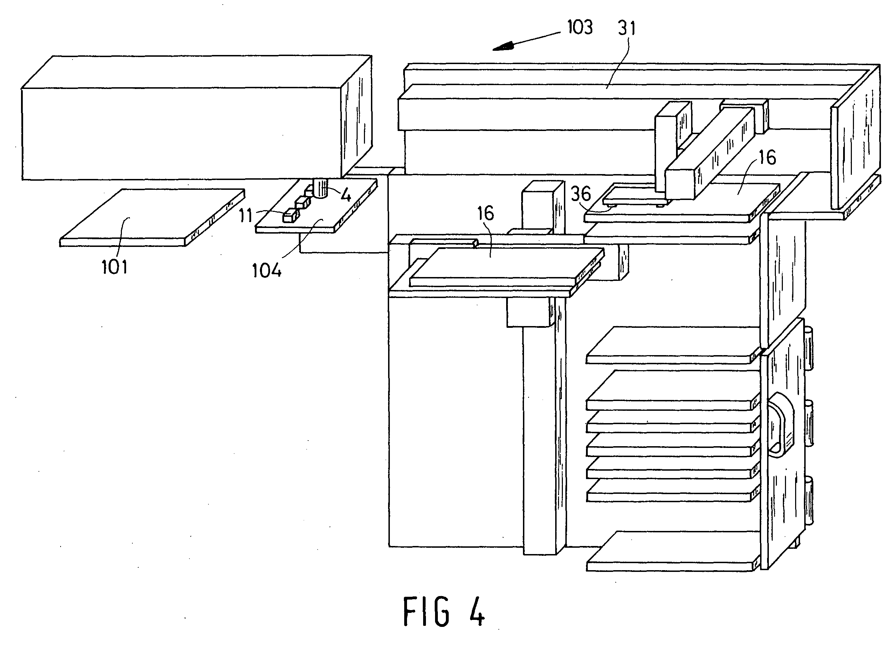

Fig. 4 shows another embodiment of a component placement apparatus 103 according to the invention whereby the buffer 104 comprises three component pickup positions on which components 11 can be temporarily stored and which positions are in line with each other. The component pickup positions are also in line with the component pickup location 102 and spaced apart over the same distance as the component pickup locations 102 so that for the controller of the component placement apparatus 103 there is no difference for picking up components delivered to the component placement apparatus in reels 8 or in trays 16.

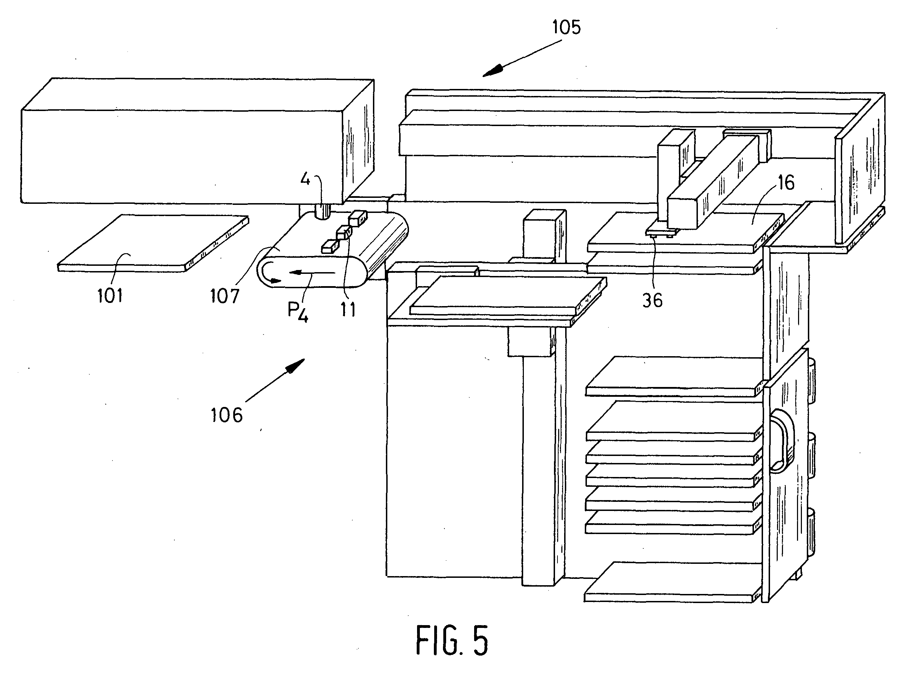

Fig. 5 shows a perspective view of another embodiment of a component placement apparatus 105 of the invention whereby the buffer 106 comprises an endless belt 107 which is driven by a motor in a direction indicated by arrow P4. A component is being picked up by the pick and place device 36 from the tray 16 and placed on the belt 107 on a side near the tray 16. The belt 107 is being moved in the direction indicated by arrow P4 so that the component 11 can be picked up by the pick and place device 4 relatively close to the substrate 101 on which the component 11 needs to be placed. In this manner it is possible to place a component on one side of the belt 107 whilst at the same time another component is being picked up from the belt 107.

The controller comprises a collision prevention means for preventing collision between the pick and place devices 4, 36.

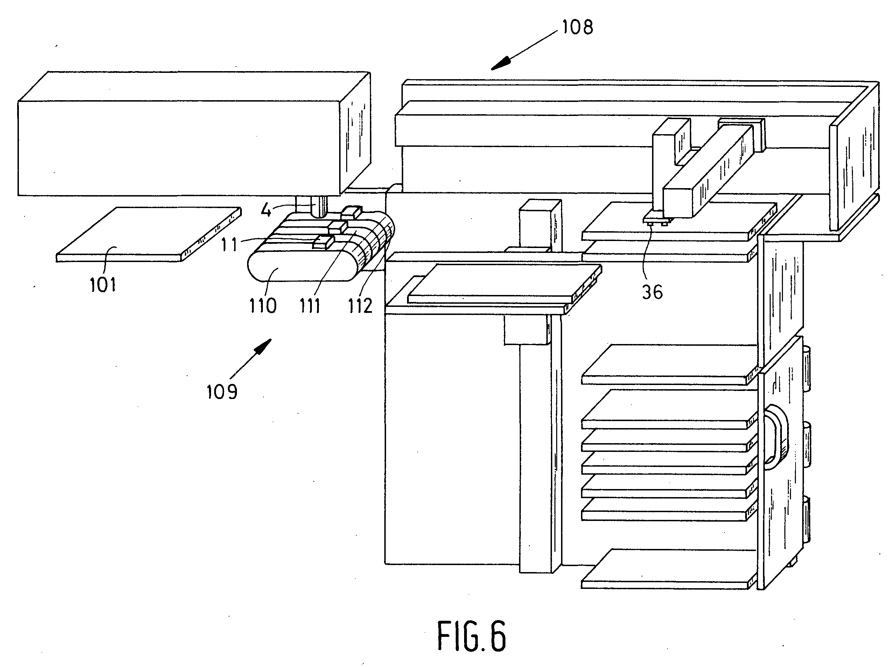

Fig. 6 shows another embodiment of a component placement apparatus 108 which differs from the component placement apparatus 105 in that the buffer 109 comprises three independently driven belts 110, 111, 112, whereby on each belt 110, 111, 112 a number of components 11 can be temporarily stored. The advantage of the independently driven belts 110, 111, 112 is that by means of each belt a component can be presented relatively close to the substrate 101 whilst at the same time another component can be placed on the belt.

If desired it is possible to even optimize the sequence of the trays 16 in the first part 17 so that the time necessary to present a tray at the pickup area and to present another tray at the pickup area is further reduced.

It is also possible to optimize the sequence of the trays in the second part 18 by means of the controller so that for example all empty trays are located in the slots 15 which are the farrest away from the pickup are whilst the trays with components are stored in the slots 15 closer to the first part 17.

Although it is preferred that the tray transporting device is being moved along the slots, it is also foreseen that the tray storing device 14 is being moved up and down, whereby the trays which are needed on the short term are located in the middle part, the trays which are emptied are stored in the lower part and the trays which are provided with components which are expected not to be needed in the short term are located in an upper part of the tray storing device 14.

It is also possible to provide the tray storing device with a third part, located on the left side of the vertical column 21 (Fig. 2) and located below the transport device 3. The third part can be filled with trays in a manner similar as the first part 17. In said third part trays can be stored which are not expected to be needed in the short term.

It is also possible to use the tray storing device for storing stacks of trays, whereby a single tray can be removed from the stack loaded in the upper part whilst the remaining part of the stack is stored in the lower part.

It is also possible to use the tray storing device for storing wafers carrying components.

## Claims

1. Component placement apparatus (1) comprising a tray storing device (14) for storing at least one tray (16) containing electronic components and at least one component pick and place device (36), **characterized in that** the component placement apparatus (1) comprises a buffer (37) on which components picked up from the tray (16) by means of a first component pick and place device (36), are temporarily stored whilst the component placement apparatus (1) comprises a second pick and place device (4) for picking up a component from the buffer (37) and placing the component on a substrate (101).

2. Component placement apparatus (1) according to claim 1, **characterized in that** the buffer (37) comprises at least one component pickup position in a pickup area on which a component can be temporarily stored.

3. Component placement apparatus (1) according to claim 1 and 2, comprising a number of tape feeders each comprising a component pickup location, whereby the component pickup locations are in line with the at least one component pickup position of the buffer (37).

4. Component placement apparatus (1) according to one of the preceding claims, **characterized in that** the buffer (37) comprises a matrix of component pickup positions on which components can be temporarily stored.

5. Component placement apparatus (1) according to one of the preceding claims, **characterized in that** components can be temporarily stored on random positions on a pickup area of the buffer (37).

6. Component placement apparatus (1) according to one of the preceding claims, **characterized in that** the component placement apparatus (1) comprises a controller for allocating the components to a specific position on the buffer (37) and controlling the movement of the pick and place devices to place a component on and pick up a component from the correct position on the buffer (37).

7. Component placement apparatus (1) according to claim 6, **characterized in that** the controller comprises a collision prevention means for preventing collision between the pick and place devices.

8. Component placement apparatus (1) according to one of the preceding claims, **characterized in that** the buffer (37) comprises at least one endless belt on which at least one component can be temporarily stored whilst the component can be moved by means of the endless belt from a position closer to the tray (16) to a position closer to the substrate (101).

9. Method for operating a component feeding device comprising a tray storing device (14) for storing at least one tray (16) containing electronic components and at least one component pick and place device (36), **characterized in that** a component is picked up by a first pick and place device and placed on a buffer (37), where the component is temporarily stored, after which the component is being picked up by a second pick and place device (4) and placed on a desired location on a substrate (101).
